(19) **Europäisches Patentamt**
**European Patent Office**
**Office européen des brevets**

(11) **EP 1 867 753 A1**

(12) **EUROPEAN PATENT APPLICATION**

(43) Date of publication:
**19.12.2007 Bulletin 2007/51**

(51) Int Cl.:
*C23C 30/00* *(2006.01)*   *C22C 29/08* *(2006.01)*

(21) Application number: **07107705.1**

(22) Date of filing: **08.05.2007**

<table>
<tr><td>

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **15.06.2006 SE 0601313**

</td><td>

(71) Applicant: **Sandvik Intellectual Property AB 811 81 Sandviken (SE)**

(72) Inventors:
 • **Ljungberg, Björn
   SE-122 44, Enskede (SE)**
 • **Åkesson, Leif
   SE-125 51, Älvsjö (SE)**
 • **Sadik, Ibranim
   SE-164 45, Kista (SE)**

</td></tr>
</table>

(54) **Coated inserts for milling**

(57) The present invention discloses coated cemented carbide milling inserts, particularly useful for rough and semifinishing milling of grey cast iron, highly alloyed grey cast iron, compacted graphite iron (CGI) with or without cast skin under dry conditions.

The inserts are characterised by a WC-Co cemented carbide with a low content of cubic carbides and a W-alloyed binder phase and a coating including an inner layer of $TIC_xN_y$ with columnar grains followed by a wet blasted layer of $\alpha$-$Al_2O_3$. on the rake face and coloured top layer on the clearance side.

The invention also relates to a method of making cutting tool inserts according to the above.

**EP 1 867 753 A1**

**Description**

The present invention relates to coated cemented carbide milling inserts, particularly useful for rough and semifinishing milling of grey cast iron, highly alloyed grey cast iron, compacted graphite iron (CGI) with or without cast skin under dry conditions.

BACKGROUND OF THE INVENTION

When cemented carbide cutting tool inserts are used in machining of cast irons, the cutting edge is worn according to different wear mechanisms such as chemical and abrasive wear. Additionally a milling cutting edge is also most often subjected to so-called comb crack formation. These cracks develop perpendicularly to the cutting edge and are a result of the cycling mechanical and heat load. When the comb cracks have propagated deep enough into the carbide body the cutting edge starts to chip and fracture.

A typical characteristic of a cast iron component is its hard surface zone which structure considerably deviates from its bulk structure. The surface zone generally contains hard inclusion and sand from the mould. This makes cutting of cast iron very demanding. A cutting tool insert should also be able to cope with broad range of cutting conditions, such as various cutting speeds, depths of cut and cutting feed rates as well as manage external factors such as vibrations of the work piece.

All these factors require a plurality of properties of the cutting tool insert. Commercial cemented carbide tool inserts for milling of cast irons have usually been optimized with respect to one or two of mentioned wear types.

U.S. Patent No. 5,912,051 discloses a coated cutting insert particularly useful for dry milling of grey cast iron.

In U.S. Patent No. 6,062,776 is disclosed a coated cemented carbide cutting tool particularly designed for the wet and dry milling of workpieces of low and medium alloyed steels or stainless steels, with or without abrasive surface zones, in machining operations requiring a high degree of toughness of the carbide cutting edge. The external cutting conditions are characterized by complex shapes of the workpiece, vibrations, chip hammering, recutting of the chips etc.

In U.S. Patent No. 6,177,178 is disclosed a coated cemented carbide cutting tool particularly designed for the wet and dry milling of low and medium alloyed steels.

WO 01/16388 discloses a coated insert particularly useful for milling in low and medium alloyed steels with or without abrasive surface zones during dry or wet conditions at high cutting speed, and milling hardened steels at high cutting speed.

U.S. Patent No. 6,638,609 discloses coated milling inserts particularly useful for milling of grey cast iron with or without cast skin under wet conditions at low and moderate cutting speeds and milling of nodular cast iron and compacted graphite iron with or without cast skin under wet conditions at moderate cutting speeds.

US Patent Application 2006/0115683 discloses coated milling inserts particularly useful for milling of grey cast iron with or without cast skin under dry conditions at preferably rather high cutting speeds and milling of nodular cast iron and compacted graphite iron with or without cast skin under dry conditions at rather high cutting speeds. The inserts are characterised by a WC-Co cemented carbide with a low content of cubic carbides and a highly W-alloyed binder phase and a coating including an inner layer of $TiC_xN_y$ with columnar grains followed by a wet blasted layer of $\alpha$-$Al_2O_3$.

OBJECT OF THE INVENTION

It is the object of present invention to provide coated cemented carbide cutting tool inserts with significantly improved cutting performance over corresponding prior art inserts particularly useful for rough milling under dry conditions of grey cast iron, highly alloyed grey cast iron, and compacted graphite iron preferably at higher cutting speeds.

It has now surprisingly been found that improved properties of milling cutting tool inserts can be obtained with respect to the different wear types prevailing at the above mentioned cutting operations if the inserts comprise: a cemented carbide body with a W-alloyed binder phase and with a well balanced chemical composition and a certain grain size of the WC, a columnar $TiC_xN_y$ -layer and a post treated $\alpha$-$Al_2O_3$ top layer.

According to the present invention coated cutting tool inserts are provided comprising a cemented carbide body with a composition of 7.3-7.9 wt-% Co, preferably 7.5-7.7 wt-% Co, 1.0-2.0 wt-%, preferably 1.3-1.7 wt-%, cubic carbides of the metals Ta, Nb and Ti and balance WC, preferably 90.6-91.2 wt-% WC. The Ti-content is preferably on the level of technical impurity or 0. The coercivity, Hc, should have a value in the range 13.8-15.7 kA/m, preferably within 14.2-15.2 kA/m.

The cobalt binder phase is alloyed with W. The content of W in the binder phase is expressed as the

$$CW\text{-}ratio = magnetic\text{-}\%\ Co\ /\ wt\text{-}\%\ Co$$

where magnetic-% Co is the weight percentage of magnetic Co and wt-% Co is the weight percentage of Co in the cemented carbide.

The CW-value is a function of the W content in the Co binder phase. A CW-value of 0.75-0.8 corresponds to a very high W-content in the binder phase whereas a CW-ratio of 1 corresponds in principle to no W-alloying.

According to the present invention improved cutting performance is achieved if:

A) the cemented carbide body has a cobalt binder alloyed with W corresponding to a CW-ratio of 0.85-0.94, preferably of 0.88-0.92 and
B) the inserts have an 25-50 $\mu$m edge rounding before coating.
C) the coating comprises

- a first, innermost layer of $TiC_xN_yO_z$ with x+y+z=1, y>x and z<0.2, preferably y>0.8 and z=0 and a total thickness of 0.1-1.5 $\mu$m, preferably > 0.4 $\mu$m.
- a second layer of $TiC_xN_y$ with x+y=1, x>0.3 and y>0.3, with a thickness of 4.5-9.5 $\mu$m, preferably 5-7.5 $\mu$m, with columnar grains.
- a third layer of $TiC_xN_yO_z$ with x+y+z=1, x>0.3 and z>0.3, 0≤y<0.2, with a thickness of 0.3-1.5 $\mu$m.
- a fourth layer of a smooth $\alpha$-$Al_2O_3$ with a thickness of 9-15 $\mu$m, preferably 10-12 $\mu$m and a surface roughness in the cutting area zone of Ra<0.4 $\mu$m over a length of 10 $\mu$m.
- The ratio of layer thicknesses of the fourth layer $Al_2O_3$ and the second layer of $TiC_xN_y$ is preferably 1.3-2.4.
- a 0.1-2 $\mu$m thick coloured top layer, preferably TiN or ZrN on the clearance side.

The present invention also relates to a method of making coated cutting tool inserts consisting of a cemented carbide body with a composition of 7.3-7.9 wt-% Co, preferably 7.5-7.7 wt-% Co, 1.0-2.0 wt-%, preferably 1.3-1.7 wt-%, cubic carbides of the metals Ta, Nb and Ti and balance WC, preferably 90.6-91.2 wt-% WC. The Ti-content is preferably on the level of technical impurity or less, down to 0. The manufacturing conditions are chosen to obtain an as sintered structure with the coercivity, Hc, of 13.8-15.7 kA/m, preferably 14.2-15.2 kA/m and a cobalt binder phase alloyed with W corresponding to a CW-ratio of 0.85-0.94, preferably 0.88-0.92 defined as above. After wet blasting the inserts to 25-50 $\mu$m edge rounding a coating comprising the following layers is deposited:

- a first, innermost layer of $TiC_xN_yO_z$ with x+y+z=1, y>x and z<0.2, preferably y>0.8 and z=0 and a total thickness 0.1-1.5 $\mu$m preferably >0.4 $\mu$m, using known CVD-methods,
- a second layer of $TiC_xN_y$ with x+y=1, x>0.3 and y>0.3, preferably x>0.5, with a thickness of 4.5-9.5 $\mu$m, preferably 5-7.5 $\mu$m, with columnar grains using the MTCVD-technique with acetonitrile as the carbon and nitrogen source for forming the layer in the temperature range of 700-900°C. The exact conditions, however, depend to a certain extent on the design of the equipment used,
- a third layer of $TiC_xN_yO_z$ with x+y+z=1, x>0.3 and z>0.3, 0≤y<0.2, with a thickness of 0.3-1.5 $\mu$m produced by CVD using the reaction mixtures $TiCl_4$, CO, $H_2$ or $TiCl_4$, CO, $H_2$, $N_2$.
- a fourth layer of a smooth $\alpha$-$Al_2O_3$, with a thickness of 9-15 $\mu$m, preferably 10-12 $\mu$m using known CVD-methods.

The ratio of layer thicknesses of the fourth layer $Al_2O_3$ and the second layer of $TiC_xN_y$ is preferably 1.3-2.4.

- a 0.1- 2 $\mu$m thick coloured top layer, preferably TiN or ZrN using CVD or PVD-technique.

Finally, the $Al_2O_3$-layer on the rake face and along the cutting edge line is subjected to an intense wet blasting operation to obtain a smooth surface finish, preferably with a surface roughness in the cutting area zone of Ra<0.4 $\mu$m over a length of 10 $\mu$m using a slurry comprising $Al_2O_3$ grits and water. Alternatively, this wet-blasting step may be performed prior to the deposition of the coloured top layer on the clearance faces.

The invention also relates to the use of a cutting tool insert as described above for dry the milling of cast irons such as grey cast iron, highly alloyed grey cast iron or compacted graphite iron at a cutting speed of 150-375 m/min and a feed of 0.1-0.35 mm/tooth depending on cutting speed and insert geometry.

Example 1 (Invention)

Cemented carbide milling blanks were pressed in styles R245-12T3M-KM, R290-12T308M-KM and SPKN1204 EDR from powder with the composition 7.6 wt-% Co, 1.25 wt-% TaC, 0.30 wt-% NbC and balance WC and sintered with normal technique at 1410°C giving as-sintered inserts with an Hc value of 14.7 kA/m and a magnetic Co-content of 6.85 wt-% corresponding to a CW-ratio of 0.90. The inserts were edge rounded using a wet blasting method to a radius of 35 $\mu$m and then coated with a first 0.5 $\mu$m thick $TiC_xN_y$-layer with a high nitrogen content corresponding to a y-value of about 0.95, followed by a second 6 $\mu$m thick TiC$_x$N$_y$-layer, with an x-value of about 0.55 and with a columnar grain structure using MTCVD-technique (temperature 850-885 °C and CH$_3$CN as the carbon/nitrogen source). In subsequent steps during the same coating cycle a third 1 $\mu$m thick Ti(C,O)-layer was deposited followed by a fourth 11 $\mu$m thick layer of $\alpha$-Al$_2$O$_3$ and a 1 $\mu$m thick top layer of TiN.

The inserts were wet blasted on the rake face with alumina grit in order to remove the top TiN-layer and to produce a smooth surface finish of the exposed Al$_2$O$_3$-layer of Ra=0.2 $\mu$m over a length of 10 $\mu$m.

Example 2 (Prior art)

Cemented carbide milling inserts according to table 1 with the same insert styles as in example 1 were produced according to known technique.

Table 1

| Variant | Substrate composition, wt-% | | | | Hc, kA/m | CW-ratio | Coating thickness, $\mu$m and type | |
|---------|------|------|------|------|---------|---------|---------------|-----------------|
| | Co | TaC | NbC | WC | | | | |
| Ref A | 6.0 | - | - | Rest | 16.1 | 0.94 | 5.5 TiCN, | 4.0 $\alpha$-Al$_2$O$_3$ |
| Ref B | 7.6 | 1.25 | 0.27 | Rest | 14.8 | 0.91 | 7.1 TiCN, | 7.0 $\alpha$-Al$_2$O$_3$ |

Example 3

Inserts from example 1 according to the present invention were tested in a face milling of cylinder heads in highly alloyed grey cast iron.
Tool: R245-12T3M-KM
Number of inserts in the cutter: 24 pcs
Criterion: Surface finish and work piece frittering.
Reference: R245-12T3M-KM, prior art Ref A from example 2

Cutting data

| | | |
|---|---|---|
| Cutting speed: | Vc | =350 m/min |
| Feed rate: | Fz | =0.15 mm per tooth |
| Depth of cut: | Ap | =0.5 mm |

Dry conditions

The tool life of Ref A was 174 cylinder heads and 215 cylinder heads for inserts according to the invention was measured.
Results: Increased tool life by 23 % and improved surface finish with the inserts according to the invention.

Example 4

Inserts from example 1 according to the invention were tested in a face milling of central block in highly alloyed grey cast iron.
Tool: R245-12T3M-KM
Number of inserts in the cutter: 10 pcs
Criteria: Surface finish and work piece frittering.
Reference R245-12T3M-KM, prior art Ref A from example 2.

Cutting data

| | | |
|---|---|---|
| Cutting speed: | Vc | =251 m/min |

(continued)

| Feed rate: | Fz | =0.24 mm per tooth |
|---|---|---|
| Depth of cut: | Ap | =2-3 mm |

Dry conditions

The tool life as an average of two tests was 50 minutes for Ref A and 80 minutes for inserts according to the invention.

Example 5

Inserts from example 1 according to the present invention were tested in face milling of a Hub swivel for a generator engine made of grey cast iron
Tool: SPKN1204 EDR
Number of inserts in the cutter: 8 pcs
Criteria: Surface finish and work piece frittering.
Reference SPKN1204 EDR, prior art Ref B from example 2.

Cutting data

| Cutting speed: | Vc | =350 m/min |
|---|---|---|
| Feed rate: | Fz | =0.19 mm per tooth |
| Depth of cut: | Ap | =3-4 mm |

Dry conditions

The tool life of Ref B and of inserts according to the invention was 38 and 56 minutes, respectively.

Example 6

Inserts from example 1 according to the present invention were tested in a face milling of cylinder heads in compacted graphite iron (CGI).
Tool: R290-12T308M-KM
Number of inserts in the cutter: 6 pcs
Criterion: Surface finish and work piece frittering.
Reference: R290-12T308M-KM, prior art Ref A from example 2.

Cutting data

| Cutting speed: | Vc | =300 m/min |
|---|---|---|
| Feed rate: | Fz | =0.15 mm per tooth |
| Depth of cut: | Ap | =3.0 mm |

Dry conditions

The tool life of Ref A and the inserts according to the invention was 60 cylinder heads and 85 cylinder heads, respectively.

From examples 3-6 it is evident that the insert according to the invention shows much better cutting performance than inserts according to prior art. The main advantage is a slower growth of the flank and crater wear, due to a well balanced composition of the cemented carbide body together with a very big total coating thickness.

**Claims**

1. A cutting tool insert for milling under dry conditions of grey cast iron, highly alloyed grey cast iron and compacted graphite iron (CGI), with or without cast skin, comprising a cemented carbide body having a coating **characterized in that** said cemented carbide body has an edge radius of 25-50 $\mu$m comprises WC, 7.3-7.9 wt-% Co and 1.0-2.0 wt-% cubic carbides of the metals Ti, Ta and Nb, a CW-ratio of 0.85-0.94, a coercivity, Hc, of 13.8-15.7 kA/m and **in that** said coating comprises

   - a first, innermost layer of $TiC_xN_yO_z$ with x+y+z=1, y>x and z<0.2 and a total thickness of 0.1-1.5 $\mu$m,
   - a second layer of $TiC_xN_y$ with x+y=1, x>0.3 and y>0.3, with a thickness of 4.5-9.5 $\mu$m, with columnar grains,
   - a third layer of $TiC_xN_yO_z$ with x+y+z=1, x>0.3 and z>0.3, 0≤y<0.2, with a thickness of 0.3-1.5 $\mu$m,
   - a fourth layer of a smooth $\alpha$-$Al_2O_3$ with a thickness of 9-15 $\mu$m , preferably with a surface roughness in the cutting area zone of Ra<0.4 $\mu$m over a length of 10 $\mu$m and
   - a 0.1- 2 $\mu$m thick coloured top layer on the clearance side, preferably of TiN or ZrN.

2. A cutting tool insert for milling according to claim 1 **characterized in** a Ti-content on the level of technical impurity or less.

3. A cutting tool insert for milling according to claim 1 or 2 **characterized in that** the cemented carbide body contains 1.3-1.7 wt-% carbides of Ta and Nb.

4. Method of making a milling cutting tool insert comprising a cemented carbide body and a coating **characterized in**

   - providing a cemented carbide body comprising WC, 7.3-7.9 wt-% Co and 1.0-2.0 wt-% cubic carbides of the metals Ti, Ta and Nb and a W-alloyed binder phase with a CW-ratio of 0.85-0.94, a coercivity, Hc, of 13.8-15.7 kA/m,
   - wet blasting the inserts to 25-50 $\mu$m edge rounding,
   - depositing by a CVD-method a first, innermost layer of $TiC_xN_yO_z$ with x+y+z=1, y>x and z<0.2 and a thickness of 0.1-1.5 $\mu$m,
   - depositing by an MTCVD-technique, a second layer of $TiC_xN_y$ with x+y=1, x>0.3 and y>0.3 with a thickness of 4.5-9.5 $\mu$m having a columnar grain structure, wherein the MTCVD-technique uses acetonitrile as a source of carbon and nitrogen for forming a layer in a temperature range of 700-900°C,
   - depositing by a CVD-method a third layer of $TiC_xN_yO_z$ with x+y+z=1, x>0.3 and z>0.3, 0≤y<0.2, with a thickness of 0.3-1.5 $\mu$m,
   - depositing a fourth layer of $\alpha$-$Al_2O_3$ with a thickness of 9-15 $\mu$m using known CVD-methods and
   - depositing a 0.1- 2 $\mu$m thick coloured top layer on the clearance side, preferably TiN or ZrN, using CVD or PVD-technique and
   - wet blasting the $Al_2O_3$-layer on the rake face and along the cutting edge line to obtain a smooth surface finish, preferably with a surface roughness in the cutting area zone of Ra<0.4 $\mu$m over a length of 10 $\mu$m using a slurry comprising $Al_2O_3$ grits in water.

5. Method according to claim 4 **characterized in** a Ti-content on the level of technical impurity or =0.

6. Method according to claim 4 or 5 **characterized in that** said cemented carbide body contains 1.3-1.7 wt-% carbides of Ta and Nb.

7. Use of a cutting tool insert according to claims 1-3 for dry milling of cast irons such as grey cast iron, highly alloyed grey cast iron, compacted graphite iron at a cutting speed of 150-375 m/min and a feed of 0.1-0.35 mm/tooth depending on cutting speed and insert geometry.

**European Patent Office**

## EUROPEAN SEARCH REPORT

Application Number

EP 07 10 7705

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 616 977 A (SANDVIK INTELLECTUAL PROPERTY [SE]) 18 January 2006 (2006-01-18) | 1-6 | INV. C23C30/00 C22C29/08 |
| Y | * page 2, paragraph 10 - paragraph 11; claims 7-9 * | 1-6 | |
| D,Y | EP 1 655 391 A (SANDVIK INTELLECTUAL PROPERTY [SE]) 10 May 2006 (2006-05-10) * column 1, paragraph 6; claims 1-3; example 3 * | 1-7 | |
| D,Y | US 5 912 051 A (OLSSON BJOERN [SE] ET AL) 15 June 1999 (1999-06-15) * column 2, line 49 - column 3, line 59; claims 1-3; example 3 * | 1-7 | |
| Y | WO 01/16389 A (SANDVIK AB [SE]) 8 March 2001 (2001-03-08) * page 6, line 9 - line 26; claims 1-8; examples 1-3 * | 1-7 | |
| Y | US 2004/033393 A1 (NORDGREN ANDERS [SE] ET AL) 19 February 2004 (2004-02-19) * claims 1-12 * | 1-6 | TECHNICAL FIELDS SEARCHED (IPC) C22C C23C |
| A | EP 0 900 860 A2 (MITSUBISHI MATERIALS CORP [JP]) 10 March 1999 (1999-03-10) * the whole document * | 1-7 | |

The present search report has been drawn up for all claims

| Place of search | Date of completion of the search | Examiner |
|---|---|---|
| Munich | 20 July 2007 | Teppo, Kirsi-Marja |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 867 753 A1**

## ANNEX TO THE EUROPEAN SEARCH REPORT
## ON EUROPEAN PATENT APPLICATION NO.

EP 07 10 7705

This annex lists the patent family members relating to the patent documents cited in the above-mentioned European search report.
The members are as contained in the European Patent Office EDP file on
The European Patent Office is in no way liable for these particulars which are merely given for the purpose of information.

20-07-2007

| Patent document cited in search report | | Publication date | Patent family member(s) | | Publication date |
|---|---|---|---|---|---|
| EP 1616977 | A | 18-01-2006 | SE | 528109 C2 | 05-09-2006 |
| | | | SE | 0401840 A | 13-01-2006 |
| | | | US | 2006046100 A1 | 02-03-2006 |
| EP 1655391 | A | 10-05-2006 | CN | 1772423 A | 17-05-2006 |
| | | | JP | 2006192561 A | 27-07-2006 |
| | | | SE | 528380 C2 | 31-10-2006 |
| | | | SE | 0402709 A | 09-05-2006 |
| | | | US | 2006115683 A1 | 01-06-2006 |
| US 5912051 | A | 15-06-1999 | NONE | | |
| WO 0116389 | A | 08-03-2001 | AT | 286152 T | 15-01-2005 |
| | | | DE | 60017161 D1 | 03-02-2005 |
| | | | DE | 60017161 T2 | 08-12-2005 |
| | | | EP | 1218558 A1 | 03-07-2002 |
| | | | IL | 147780 A | 25-07-2005 |
| | | | JP | 2003508632 T | 04-03-2003 |
| | | | US | 6406224 B1 | 18-06-2002 |
| US 2004033393 | A1 | 19-02-2004 | NONE | | |
| EP 0900860 | A2 | 10-03-1999 | DE | 69823122 D1 | 19-05-2004 |
| | | | DE | 69823122 T2 | 26-08-2004 |
| | | | JP | 3402146 B2 | 28-04-2003 |
| | | | JP | 11077445 A | 23-03-1999 |
| | | | US | 6207262 B1 | 27-03-2001 |

EPO FORM P0459

For more details about this annex : see Official Journal of the European Patent Office, No. 12/82

8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5912051 A
- US 6062776 A
- US 6177178 B
- WO 0116388 A
- US 6638609 B
- US 20060115683 A